# EUROPEAN PATENT SPECIFICATION

(11) **EP 1 841 064 B1**
(45) Date of publication and mention of the grant of the patent: **15.10.2008**
(21) Application number: 07105353.2
(22) Date of filing: 30.03.2007
(51) Int. Cl.: H03H 9/215

(54) **Quartz resonator, quartz resonator package, and quartz oscillator**
Quarzresonator, Quarzresonatorpaket und Quarzoszillator
Résonateur à quartz, paquet de résonateur à quartz et oscillateur à quartz

(30) Priority: 31.03.2006 JP 2006100567
(43) Date of publication of application: 03.10.2007
(73) Proprietor: Nihon Dempa Kogyo Co., Ltd., Shibuya-ku Tokyo 151-8569 (JP)
(72) Inventor: Umeki, Mitoshi, c/o Nihon Dempa Kogyo Co., Ltd., Sayama-shi Saitama 350-1321 (JP)
(74) Representative: TBK-Patent

(56) References cited:
- EP-A- 1 217 735
- EP-A2- 0 451 992
- US-A1- 2004 095 199

## Description

### BACKGROUND OF THE INVENTION

### 1. FIELD OF THE INVENTION

The present invention relates to a tuning fork type quartz resonator from which two vibrating arms are protruding, and a quartz resonator package to house the crystal resonator.

### 2. DESCRIPTION OF THE RELATED ART

Since the tuning fork type quartz resonator is small in size, and low in price and power consumption, it has been used as a signal source for keeping time accurately for years. In recent years, it has been adopted as a synchronizing signal source for portable electronic devices, and such uses are becoming more common.

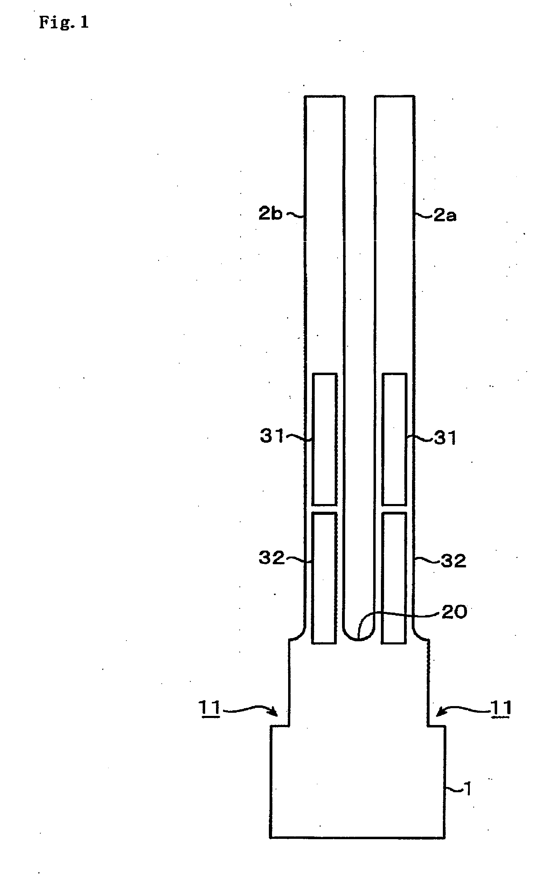

Showing a structural example of the tuning fork type quartz resonator in FIG. 1. it includes a pair of vibrating arms 2a and 2b provided to a base 1, and grooves 31 and 32 on both main surfaces of the respective arms 2a and 2b. On both side surfaces of these grooves 31 and 32, and the respective arms 2a and 2b, excitation electrodes to elicit tuning fork oscillations caused by winding oscillation of the respective arms 2a and 2b are provided. The excitation electrodes are wired to obtain the state that the side surface of the arm 2a and the insides of the grooves 31 and 32 of the other arm 2b are at the same potential, and the side surface of the other arm 2b and the insides of the grooves 31 and 32 of the arm 2a are at the same but the reverse potential to the side surface of the arm 2a.

According to such a tuning fork type quartz resonator, the directions of the electric field generated on both main surfaces and both side surfaces face in the opposite directions between the respective arms 2a and 2b. Then, the winding oscillations in the longitudinal direction in the respective arms 2a and 2b also face in opposite directions, which creates tuning fork oscillation. It is desirable here from a view point of suppressing consumption energy to convert the electrical energy emitted by the tuning fork type quartz resonator into tuning fork oscillation efficiently. Accordingly, various schemes to lower oscillation loss (crystal impedance (CI) value) during the conversion of electrical energy into tuning fork oscillation have been conducted.

For instance, when the tuning fork type quartz resonator shown in FIG. 1 is provided with grooves 31 and 32, the CI value is lowered by intensely exciting the winding oscillation between both side surfaces of the respective arms 2a and 2b by increasing the electric field intensity in an X axial direction (the width direction of the vibrating arm) in these grooves 31 and 32.

In general, the excitation electrode is made of gold (Au) or the like in a film structured by vacuum evaporation, sputtering or the similar process on a chromium (Cr) film in order to improve adhesiveness to the quartz resonator. Since, however, gold (Au) has high specific gravity of about 7.3 times (18.9) that of quartz crystal and is high in stiffness, an electromechanical combination coefficient (a coefficient expressing a capacity to convert electric energy into mechanical (tuning fork oscillation) energy) is low. Therefore, an electrode material capable of further lowering the CI value has been demanded.

It should be noted that the quartz resonator package described in Patent Document 1 is made by anodic junction between a cover made of glass containing a movable ion such as sodium ion and an on-board substrate made of silicon substrate. Thus, a silicon material used in the present invention is described. However, the uses and the purpose thereof are completely different from those in the present invention. Accordingly, it is impossible to solve the above-described problems with the technology described in Patent Document 1.

### [Patent Document 1]

Japanese Patent Application Laid-open 2004-193909: page 3, column 18 and page 4, column 24

### SUMMARY OF THE INVENTION

The present invention is achieved in consideration of these circumstances, aimed at providing a tuning fork type quartz resonator having a low CI value. Another object of the present invention is to provide a crystal package provided with this kind of quartz crystal.

A quartz resonator relating to the present invention having electrode patterns including an excitation electrode and a pull out electrode on both front and back surfaces of a quartz crystal piece from which two vibrating arms are extending from a base in a tuning fork shape, in which at least the excitation electrode out of the above-described electrode patterns is made from a silicon material consisting of polysilicon or amorphous silicon.

It is suitable to use a p-type or an n-type impurity-doped material as the silicon material. In addition, it is preferable that the silicon material is deposited on the vibrating arm at a temperature lower than the Curie point of the quartz crystal making up the quartz resonator. Furthermore, it is preferable that a frequency adjusting metal film having greater specific gravity than that of the above-described silicon is formed at the front-end portion of the vibrating arm.

A quartz resonator package relating to the present invention includes:
a package, the quartz resonator provided in the package and having the above-described characteristics, and an electrode provided on the outside of the package and electrically connected to the electrode pattern of the quartz resonator.

According to the present invention, a silicon material having specific gravity lower than gold (Au) which is conventionally used is used as a material for the electrode pattern. Furthermore, since the silicon material is closer in stiffness to that of quartz crystal than gold (Au), it becomes possible to lower the CI value. This is because the smaller in stiffness the larger an electromechanical combination coefficient (a coefficient expressing a capacity to convert electric energy into mechanical (tuning fork oscillation) energy). As a result, compared with the conventional type quartz resonator using gold (Au) as a electrode material, the CI value is reduced, which in turn makes it possible to manufacture a quartz resonator low in energy consumption, and a package provided with this quartz resonator.

### BRIEF DESCRIPTION OF THE DRAWINGS

FIG. 1 is a diagrammatic plan view showing an example of the tuning fork type quartz resonator;
FIG. 2 is a plan view showing an example of the tuning fork type quartz resonator relating to the present embodiment;
FIG. 3 is a schematic view diagrammatically showing an example of the tuning fork type quartz resonator relating to the present embodiment;
FIG. 4 is a plan view showing an example of the prototype of a quartz resonator manufactured in a manufacturing process of the tuning fork type quartz resonator relating to the present embodiment; and
FIGs. 5A and 5B are a vertical cross-sectional view and a back view showing an example of a quartz resonator package which houses the tuning fork type quartz resonator relating to the present embodiment.

### DETAILED DESCRIPTION OF THE PREFERRED EMBODIMENT(S)

The tuning fork type quartz resonator shown in FIG. 1 which is explained in the description of the related art is applicable to the quartz resonator relating to the present embodiment. The shape of the quartz resonator will be described in detail as follows. The main body of the quartz resonator (quartz crystal piece) includes a substantially square-shaped base 1 provided with a cut-out portion 11 where the upper side of both side portions are cut out in a rectangular shape, and two pieces (a pair) of vibrating arms 2 (2a and 2b) extended in parallel from the upper end side of the base 1 separated from each other at a space between them, and is structured as a tuning fork shaped quartz crystal piece. On the main surfaces on the front side and the back side of the vibrating arms 2 (2a and 2b), formed are grooves 31 and 32 respectively divided into two equal parts in the longitudinal direction from the base portion of the respective vibrating arms 2 (2a and 2b) towards the front-end side thereof. When electric charge is supplied to the quartz resonator, the grooves 31 and 32 increase the electric field intensity formed in the vibrating arms 2a and 2b so that they serve to strengthen the winding oscillation of the respective arms 2a and 2b. Furthermore, by forming a bridge between two grooves 31 and 32, the resistance to a shock occurring during a fall is strengthened. It should be noted that a quartz resonator without grooves or with a different number of grooves or shape other than that shown as the example may be used.

The planar shape of the base 1 between the pair of vibrating arms 2a and 2b is curved, and the respective grooves 32 on the base 1 sides of the respective arms 2a and 2b are formed making inroads toward the lower side of the base 1 a little further than the lowest portion (assuming that the front-end side of the vibrating arm 2 is the upper side) 20 of the curved portion (crotch portion of the tuning fork).

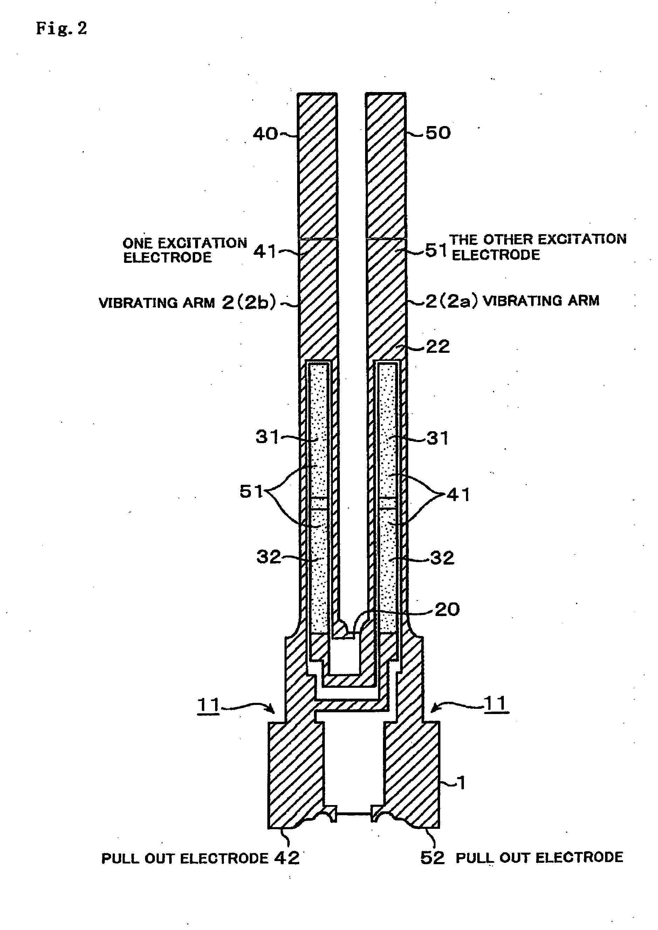

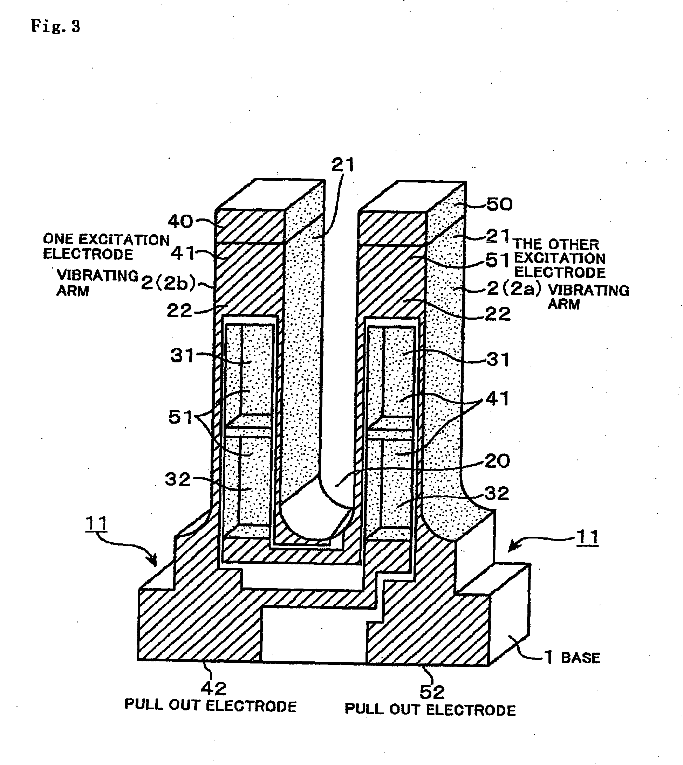

FIG. 2 is a plan view including an electrode pattern, and FIG. 3 is a perspective view schematically showing the quartz resonator in FIG. 1. The excitation electrode and the pull out electrode will be explained in reference to these drawings. The quartz resonator is provided with one electrode and the other electrode making a pair, one and the other electrodes. Regarding the vibrating arm 2a, the one electrode 41 is formed between the whole inside surfaces of two grooves 31 and 32 of the vibrating arm 2a and the space formed between these grooves 31, 32. In other words, by the excitation electrode 4 formed on a so-called bridge which corresponds to the space between the grooves 31 and 32, the excitation electrodes 41, 41 in the respective grooves 31, 32 of the vibrating arm 2a are connected. The other electrode 51 is formed on both sides 21 and 21 of the vibrating arm 2a and a portion on the main surfaces 22 and 22 (front and back) upper than the second groove 31 on the front-end side. At the front-end of the arm 2a, provided is an adjusting weight 50 which is a metal film to adjust the oscillation frequency by changing the weight of the arm. The adjusting weight 50 is a portion of the excitation electrode 51, but differs in, for instance, thickness of the film or the material of the electrode from other portion of the electrode. Note that the excitation electrodes 41 and 51 are expressed using a slanting line area and a black dot area to make the drawing easier to see in FIG. 3. Therefore, the slanting lines in FIG. 3 are not for showing a cross section.

As for the vibrating arm 2b, the other excitation electrode 51 is formed on the whole inside surfaces of the two grooves 31 and 32 of the vibrating arm 2b and the space between these grooves 31 and 32. The one electrode 41 is formed on both side surfaces 21 and 21 of the vibrating arm 2b and a portion on the main surfaces 22 and 22 (front and back) upper than the second groove 32 on the front-end side. At the front-end of the arm 2a, provided is an adjusting weight 40 to adjust the oscillation frequency by changing the weight of the arm in a similar fashion. The arrangement of the electrodes provided on the vibrating arms 2a and 2b are similar to each other except that the excitation electrodes 41 and 51 are in reverse relation. An electrode pattern consisting of a pull out electrode 42 is formed on the surface of the base 1 so that the one excitation electrodes 41 and 41 are electrically connected, and at the same time, an electrode pattern consisting of a pull out electrode 52 is formed on the surface of the base 1 so that the other excitation electrodes 51 and 51 are electrically connected.

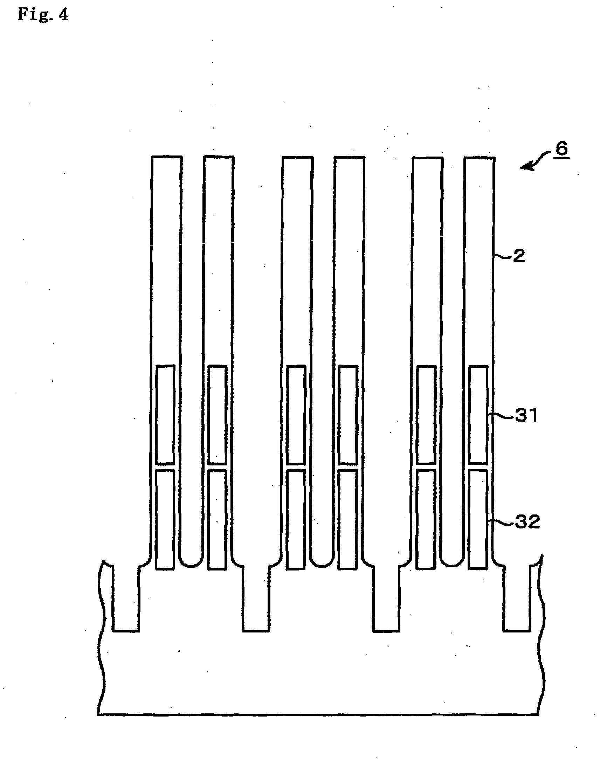

Next, the process of manufacturing the quartz resonator will be explained. First, using a Z-cut quartz crystal, for instance, on both whole surfaces of a quartz crystal wafer of 3 inch in diameter and 100 µm in thickness, a chromium (Cr) film for improving the adhesion and a gold (Au) film as a metal mask are formed by a vapor deposition method. A resist is coated on the gold (Au) film to expose a gold (Au) film at a place corresponding to an outer frame of the quartz resonator which amount to, for instance, several thousand pieces by photolithography. Then, using a potassium iodide (KI) solution, the exposed gold (Au) film and chromium (Cr) film are removed to expose the quartz crystal at this portion. The exposed quartz crystal is removed by etching with hydrofluoric acid. By this process, for instance, the original form 6 of the main body of the quartz resonator shown in FIG. 4 is manufactured. At this time, the grooves 31, 32 and others have not yet been formed. Here, since the resist film is fallen off from the quartz crystal surface by hydrofluoric acid, only the gold (Au) film and its backing chromium (Cr) film which are unaffected by hydrofluoric acid still remain.

Next, the resist film is coated again on both surfaces of the original form 6, and the gold (Au) film at the place corresponding to the grooves 31 and 32 of respective quartz resonators are exposed by photolithography. Then, using a potassium iodide (KI) solution, the exposed gold (Au) film and the chromium (Cr) film are removed to expose the quartz crystal at this place. The grooves 31 and 32 are formed at portions corresponding to the respective vibrating arms 2 of the original form 6 by removing a portion of the exposed quartz crystal by etching with hydrofluoric acid as shown in FIG. 4. By the above processes, the original form 6 is manufactured, though the electrode pattern is not yet formed.

Next, in the process of preparing the electrode pattern, an n-type amorphous silicon film (referred to as a silicon film hereinafter) in which, for instance, phosphorus (P) is doped as an impurity) is deposited on both surfaces of the original form 6 manufactured in the previous process by, for instance, chemical vapor deposition (CVD). Here, by setting the temperature during the CVD process at a temperature lower than the Curies point (about 573°C) of the quarts crystal, it is possible to form a silicon film on the quartz crystal without transforming the quartz crystal. Next, a resist is coated on the silicon film, and the silicon film at the place where the electrode pattern is not formed is exposed by a photolithography. Thereafter, the exposed silicon film is removed by plasma dry etching using a gas such as sulfur hexafluoride (SF₆) or the like so that only the electrode pattern remains. Then, only the front-end portions (places corresponding to the adjusting weights 40 and 50 in FIG. 3) of the respective vibrating arms 2 are exposed by removing the resist. Thereafter, the original form 6 is covered with a metal mask, and the adjusting weights 40 and 50 are formed by forming a gold (Au) film on the exposed portion by, for instance, a vacuum evaporation method. After these steps, the original form 6 on which the electrode pattern, etc. are formed is prepared. After measuring and adjusting the oscillation frequency of the original form 6 are conducted, the respective quartz resonators are separated. The separated quartz resonators are sent to the following packaging process. It should be noted that the silicon film formed on the surface of the original form 6 is not limited to the n-type amorphous silicon, it may be a p-type to which, for instance, boron (B) is doped as an impurity. Furthermore, it is possible to form a polysilicon film instead of amorphous silicon. These silicon materials have sufficient conductivity to be able to function as an electrode.

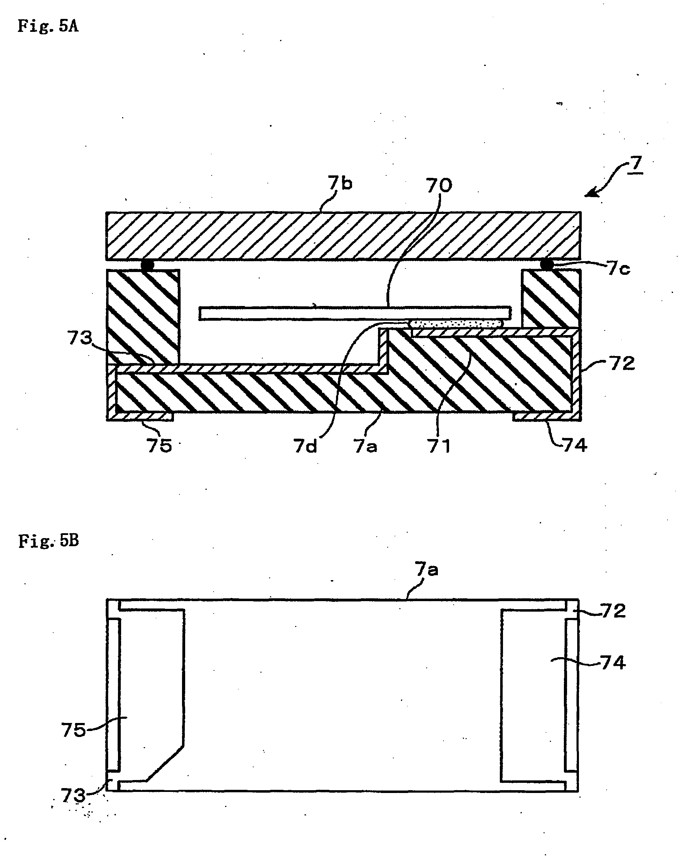

The quartz resonator on which the electrode pattern and the like are formed and separated from the original form 6 is housed in, for instance, a package with a surface mounted device (SMD) structure being an electronic part as shown in FIG. 5., This is shipped as a quartz resonator package. FIG. 5A is a vertical cross section of the quartz resonator package. In FIG. 5A, 7 indicates a package in which the above-described quartz resonator is housed. The package 7 includes a case body 7a having an aperture on the upper surface and made of, for instance, ceramic, and a lid body 7b made of, for instance, metal. The case body 7a and the lid 7b are seam-welded via, for instance, a sealing compound 7c made of a welding flux, and the inside thereof is in a vacuum state. Thus prepared tuning type quartz resonator 70 is fixed to a pedestal portion 71 in the package 7 at portions of the pull out electrodes 42 and 52 of the base 1 with a conductive adhesive 7d, and is disposed horizontally in a state that the vibrating arms 2 are extending in a space inside the package 7. The pull out electrodes 42 and 52 are connected to electrodes 74 and 75 disposed so as to face each other in the longitudinal direction of the outside bottom of the case body 7a through conductive paths 72 and 73 (73 is a conductive path on the inner side of the paper depicting FIG. 5) wired on the surface of the pedestal 71. The quartz resonator package is installed on a wiring board (not shown) on which circuit parts of an oscillating circuit are installed, and thus a quartz oscillator is completed. It should be noted that the quartz resonator package is not limited to that having the SMD structure, it may have a structure in which the quartz resonator is disposed in a metal cylinder sealed at one end thereof with an insulating material, and the respective pull out electrodes are connected to the inner ends of a pair of electrode pins penetrating through the insulating material.

The quartz resonator relating to the present embodiment will be explained next. The electrode patterns of the excitation electrodes 41, 51 or the pull out electrodes 42, 52 formed on the surface of the quartz resonator are made of silicon material. The specific gravity of the silicon material is about 2.4 which is about an eighth that of gold (Au) (about 18.9) which is generally used as an electrode. In addition, the specific gravity of the silicon material is close to that of quartz crystal (about 2.6). Therefore, the quartz resonator using a silicon material as an electrode material becomes small in mass and easier to oscillate compared with gold (Au). Moreover, the value of stiffness of silicon material is closer to quartz crystal compared with gold (Au). Therefore, the electromechanical combination coefficient (a coefficient expressing a capacity to convert electric energy into mechanical (tuning fork oscillation) energy) is large, which makes the CI value expressing difficulty of oscillation low, conversely. When the silicon material is used as the electrode material, owing to these functions created by using the silicon material, it is expected that the CI value can be reduced to about 35 kΩ or lower, whereas the CI value is about 50 kΩ to about 100 kΩ in the case of the conventional quartz resonator using, for instance, gold (Au).
It should be noted that even when the excitation electrodes 41 and 51 are formed with the silicon material, and the pull out electrodes 42 and 52 are formed with other materials, it is still in the cope of the present invention.

With the quartz resonator according to the present invention, it is possible to lower the CI value of the quartz resonator by using the silicon material consisting of polysilicon or amorphous silicon. Thereby, it becomes possible to improve the efficiency in converting electric charge into tuning fork oscillation and to lower the consumption energy.
To provide a tuning fork type quartz resonator having a low CI value and a quartz resonator package provided with the quartz resonator. A silicon material lower in specific gravity and stiffness than those of conventionally used gold (Au) is used as an electrode material for an electrode pattern such as excitation electrodes for making the tuning fork type quartz resonator generate tuning fork oscillation. By this structure, the quartz resonator is made easier to oscillate so that the oscillation loss (CI value) can be lowered during conversion of electric energy into tuning fork oscillation.

## Claims

1. A quartz resonator having electrode patterns including an excitation electrode (41, 51) and a pull out electrode (42, 52) on both front and back surfaces (22) of a quartz crystal piece from which two vibrating arms (2a, 2b) are extending from a base (1) in a tuning fork shape,
wherein at least the excitation electrode (41, 51) out of said electrode patterns is made from a silicon material consisting of polysilicon or amorphous silicon.

2. The quartz resonator according to claim 1, wherein said silicon material is a p-type or n-type to which impurities are doped.

3. The quartz resonator according to claim 1, wherein said silicon material is deposited on said vibrating arm (2a, 2b) at a temperature lower than the Curie point of the quartz crystal making up the quartz resonator.

4. The quartz resonator according to claim 1, wherein a frequency adjusting metal film (40, 50) having greater specific gravity than that of said silicon material is formed at the front-end portion of said vibrating arm (2a, 2b).

5. A quartz resonator package (7), comprising:
a package (7);
the quartz resonator (70) according to claim 1 provided in the package (7); and
an electrode (74, 75) provided outside said package (7), and electrically connected to the electrode pattern (42, 52) of said quartz resonator (70).

6. A quartz oscillator, comprising:
the quartz resonator according to claim 1.

## Patentansprüche

1. Quartzresonator mit einer Elektrodenstruktur mit einer Erregerelektrode (41, 51) und einer Ausgangselektrode (42, 52) auf sowohl einer Vorder- als auch einer Rückseite (22) eines Quartzkristallstückes, von dem sich zwei vibrierende Arme (2a, 2b) von einer Basis (1) in einer Stimmgabelform erstrecken,
wobei zumindest die Erregerelektrode (41, 51) aus der Elektrodenstruktur aus einem Siliziummaterial geformt ist, das aus Polysilizium oder amorphen Silizium besteht.

2. Quartzresonator gemäß Anspruch 1, wobei das Siliziummaterial p-leitend oder n-leitend ist, das mit Unreinheiten dotiert ist.

3. Quartzresonator gemäß Anspruch 1, wobei das Siliziummaterial bei einer Temperatur, die niedriger ist als der Curiepunkt des Quartzkristalls, der den Quartzresonator bildet, auf dem vibrierenden Arm (2a, 2b) abgelagert wird.

4. Quartzresonator gemäß Anspruch 1, wobei ein Frequenzanpassungsmetalfilm (40, 50) mit einer größeren relativen Dichte als die des Siliziummaterials an dem Vorderabschnitt des vibrierenden Arms (2a, 2b) gebildet ist.

5. Quartzresonsatorgehäuse (7), mit:
einem Gehäuse (7);
dem Quartzresonator (70) gemäß Anspruch 1, der in dem Gehäuse (7) bereitgestellt ist; und
einer Elektrode (74, 75), die außerhalb des Gehäuses (7) bereitgestellt ist, und elektrisch mit der Elektrodenstruktur (42, 52) des Quartzresonators (70) verbunden ist.

6. Quartzoszillator, mit:
dem Quartzresonator gemäß Anspruch 1.

## Revendications

1. Résonateur à quartz comportant des motifs d'électrodes incluant une électrode d'excitation (41, 51) et une électrode d'extraction (42, 52) sur à la fois les surfaces avant et arrière (22) d'un morceau de cristal de quartz duquel deux bras vibrant (2a, 2b) s'étendent à partir d'une base (1) en forme de diapason,
dans lequel au moins l'électrode d'excitation (41, 51) parmi les motifs d'électrodes est constituée d'un matériau de silicium consistant en un polysilicium ou un silicium amorphe.

2. Résonateur à quartz selon la revendication 1, dans lequel ledit matériau de silicium est un type p ou un type n dopé par des impuretés.

3. Résonateur à quartz selon la revendication 1, dans lequel ledit matériau de silicium est déposé sur ledit bras vibrant (2a, 2b) à une température inférieure au point de Curie du cristal de quartz constituant le résonateur à quartz.

4. Résonateur à quartz selon la revendication 1, dans lequel un film métallique d'ajustement de fréquence (40, 50) possédant un poids spécifique supérieur à celui dudit matériau de silicium est formé au niveau d'une portion d'extrémité avant dudit bras vibrant (2a, 2b).

5. Boîtier de résonateur à quartz (7), comprenant :
un boîtier 7 ;
le résonateur à quartz (70) selon la revendication 1 prévu dans le boîtier (7) ; et
une électrode (74, 75) prévue à l'extérieure dudit boîtier (7), et connecté électriquement au motif d'électrode (42, 52) dudit résonateur à quartz (70).

6. Oscillateur à quartz, comprenant :
le résonateur à quartz selon la revendication 1.
